# EUROPEAN PATENT SPECIFICATION

(11) **EP 1 593 313 B1**
(45) Date of publication and mention of the grant of the patent: **15.07.2009**
(21) Application number: 04706398.7
(22) Date of filing: 29.01.2004
(51) Int. Cl.: A23L 3/18, A23D 7/05, H01L 35/30, H01L 35/28

(54) **METHOD FOR HEAT TREATING A FOOD PRODUCT EMULSION AND DEVICE FOR HEAT TREATING A FOOD PRODUCT**
VERFAHREN ZUR WÄRMEBEHANDLUNG EINER LEBENSMITTELEMULSION UND VORRICHTUNG ZUR WÄRMEBEHANDLUNG EINES LEBENSMITTELS
PROCEDE DE TRAITEMENT THERMIQUE DE L'EMULSION D'UN PRODUIT ALIMENTAIRE ET INSTALLATION DESTINEE AU TRAITEMENT THERMIQUE

(30) Priority: 30.01.2003 RU 2003102487
(43) Date of publication of application: 09.11.2005
(73) Proprietor: Kurkaev, Abdul Sultanovich, Alma-Aty, 480091 (KZ)
(72) Inventor: KURKAEV, Abdul Sultanovich, Alma-Aty, 480091 (KZ); KURKAEV, Isa Sultanovich, Alma-Aty, 480091 (KZ); MANASTYRLY, Georgy Konstantinovich, St.Petersburg, 195160 (RU); ALIEVA, Elena Antonovna, St.Petersburg, 198095 (RU); LOGVINA, Natalya Vasilievna, St.Petersburg, 198330 (RU)
(74) Representative: Dunleavy, Kevin James
(86) International application number: PCT/RU2004/000038
(87) International publication number: WO 2004/066757

(56) References cited:
- DE-U1- 20 307 736
- FR-A- 2 574 253
- GB-A- 166 648
- GB-A- 316 481
- GB-A- 810 275
- RU-C1- 2 140 047
- RU-C2- 2 175 833
- US-A- 4 540 288
- US-A- 5 419 150
- US-A- 5 810 073
- US-B1- 6 236 810
- SERGEEVA A.G. PROF.: 'Rukovodstvo po tekhnologii polucheniya I pererabotki rastitelnykh macel I zhirov', vol. III, part 4 1977, LENINGRAD pages 89 - 96
- TJUTJUNNIKOV B.N. ET AL.: 'Tekhnologiya pererabotki zhirov' M. 1970, pages 3473 - 353

## Description

### TECHNICAL FIELD

This invention has been developed for the heat treatment of various eatable products and can be integrated into technological heat treatment lines in food processing industries.

### BACKGROUND OF THE INVENTION

One popular heat treatment method, involves cooling the product using a heat transferring surface of a heat exchanger, in which the product is being mixed. All of the predetermined product parameters of this technological process are met during this process.

This method is applied in numerous technological lines in the food industry (Handbook for technology of vegetable oils and fats manufacturing and processing. Volume 3. Book 2. Margarines, Mayonnaise and Mustard Production. Edition 2. Leningrad 1977 p. 89-96). For example, this method is applied in high temperature milk pasteurization apparatus, in dairy production tanks, mixers, surge drums and super coolers for margarine production, heat exchangers TOM-L for pastry and cooking fat production, Votator^{™} mixers and heat exchangers for mayonnaise and salad dressing production.

Heat and cold are produced in different units; however a refrigerant is advanced into a tube space jacket of the heat exchanger, which is designed as a "tube in tube" heat exchanger. Product in the internal tube is mixed with impellers.

This procedure suffers from the disadvantage of high power consumption for product heating and cooling.

By cooling pastry or cooking fats in the heat exchanger, for example, the exit fat temperature which is predetermined for each technological process, should be maintained by circulating intermediate coolant, such as brine, through a jacket between the cylinders. An evaporator for the cooling unit is included in the flow circuit. Higher consumption of cooling capacity results in this case because of cold losses inside of the brine flow circuit owing to the substantial temperature difference between the brine and circuit medium, as well as to the relatively lower boiling point of the coolant in the cooling unit. All these factors increase the power consumption of the refrigerating machine.

There is one way previously known to cool down the fat blends. In this case, a cooling apparatus is employed which consists of a cylindrical heat exchanger provided with a knife rotor and an ammonia refrigerating machine, including an evaporator, a condenser and a compressor. The evaporator chills the intermediate coolant, e.g. brine, which is circulating over the external cylinder surface and cooling a fat blend through the walls through the walls of the cylinder (Handbook for technology of vegetable oils and fats manufacturing and processing. Volume 3. Book 2. Margarines, Mayonnaise and Mustard Production. Edition 2. VNIIZh Leningrad 1977 p. 148-149, 347-353).

A rotating tubulator allows a substantial increase in heat emission from a viscous liquid to the cylinder walls. Disadvantages of this process are:
- Losses in cooling capacity, caused by heat resistance during heat transfer from the cylinder to the brine and from the brine to ammonia boiled in the evaporator, as well as losses along the brine's path from the evaporator to cylinder;
- Insufficient workability because of the short service life of the compressor;
- High probability of environmental contamination by ammonia.

There is an other method known for margarine emulsion cooling with an apparatus, that is equipped with a rotor, (knife rotor) installed in the cylinder and an ammonia refrigerating machine, including an evaporator integrated in the cylinder, condenser and compressor (Handbook for technology of vegetable oils and fats manufacturing and processing. Volume 3. Book 2. Margarines, Mayonnaise and Mustard Production. Edition 2. Leningrad 1977 p. 89-96 protyp)

During the production process using this apparatus, lower losses of cooling capacity are achieved. This occurs because of a decrease in heat resistance during heat transfer from the margarine emulsion to the ammonia and due to cold losses of the brine.

However, some part of the cooling capacity is lost during heat transfer from the margarine emulsion to the boiling ammonia. We should also mention the insufficient workability of the compressor on the refrigerating machine and a high probability of environmental contamination by ammonia as well.

Most like this invention is another margarine emulsion cooling process that is used during margarine production. Such a process consists of pumping the margarine emulsion into a heat exchanger, the walls of which have an internal cylindrical chilling surface. Constant mechanical treatment and emulsion advancement are performed by a floating knife system.

(Fat processing technology. B.N. Tiutiunnikov, Moscow 1979, p. 347-353).

According to this process, cooling takes place in the apparatus - an expelling chiller (Votator^{™}) by intensively mixing at a temperature 1-2°C lower than the margarine chilling point. To reach this temperature, the brine inside of chiller jacket is maintained within the limits of -14°C to - 17°C.

An expelling chiller (Votator^{™}) designed for super cooling and mechanical treatment of the margarine emulsion should consist of a series heat exchangers, equipped with a coolant jacket. Internal cylindrical walls constitute a cooling surface. Inside of each frame there is a coreless shaft rotating at the speed of 400-700 rpm This "floating" knife system consists of numerous blades mounted on the knife rotor so that they are movable at their mounting points. The number of heat exchangers depends on the machine capacity and can vary from 1 to 4. Heat exchangers are connected in series across. From the homogenizer, emulsion is pumped at a pressure of 2.5-3 Mn/m² and a temperature of 34-36°C. Having passed all the Votator^{™} sections, the emulsion comes out with temperature Exit of 10-14°C. The ammonia temperature in the evaporating chamber varies from minus 10 °C to minus 14°C. Margarine emulsion is attempered by an ammonia coolant forwarded into the Votator's^{™} evaporating chambers. Emulsion is mixed by the knife rotor of theVotator^{™} Hot water is continuously pumped through the shaft in order to prevent deposition of the cold emulsion on the working parts of the shaft.

Cold consumption for 1 MT Margarine is 138 MJ (33 000 kCal).

This is predetermined by the technological process temperature on the exit from the super cooler which is maintained by means of ammonia evaporation directly into the jacket between cylinders.

This process eliminates integration of the flow circuit for the intermediate coolant, which allows decreasing cold discharge into the environment and eliminates power losses for pumping the intermediate cooling agent.

However by performing this method, it is necessary to maintain a relatively low boiling temperature of the cooling agent, which is predetermined by the technological requirements for the margarine emulsion, on exit from the super cooler. This causes higher power consumption in the refrigerating machine, and results in higher specific energy per manufacturing product piece.

Disadvantages of this process are irregular cooling of the emulsion because of crystallization points near cylindrical walls of the frame that lead to significant congealing of the emulsion and thus causes slowing of the shaft's rotation.

Irregular cooling of the emulsion influences production output.

British patent 810,275 describes a process for the manufacture of margarine carried out using a cylindrical cooler having a diameter of 100-140 mm. In the process, margarine emulsion travels through the cooler at a bulk rate of 1200-1600 liters per hour per square meter of cooling surface. The patent indicates that this throughput rate sufficiently hardens the margarine such that a subsequent resting step to further harden the margarine can be omitted.

### DISCLOSURE OF INVENTION

This invention moves toward development of a heat treatment method for a margarine emulsion during manufacture, as well as development of a foodstuff heat treatment apparatus.

Both the elaborated method and apparatus ensure a reduction in power consumption for heat treatment of the product.

This technical result becomes apparent when regular product cooling, as well as regular crystallization point formation, is achieved by a given shaft velocity, speed of product advancement and availability of a thermoelectric battery on flat faces of the external surface of the frame of the heat exchanger.

Product output and apparatus reliability are improved, as well as improving the environmental friendliness and power efficiency.

The heat treatment method for the margarine emulsion during manufacture involves pumping the pressurized emulsion into the heat exchanger, the walls of which are provided with an internal cooling cylindrical surface, and which provides continuous mechanical treatment of the emulsion and advancement of the emulsion using the knife rotor. One distinguishing feature of this method is that it maintains the product advancement speed within the limits of 3.45 - 6.89 m/sec by employing a shaft rotation speed of 750-1440 rpm, during which time a constant temperature of the inner cooling surface of the walls is ensured by a thermoelectric battery, having its cold junctions fixed on the external surface of the frame of the heat exchanger and joined at flat surfaces.

Heat power supplied to the thermoelectric battery amounts to 2.5-5.0 Wt/cm² of the heat transfer surface of the heat exchanger.

The foodstuff heat treating apparatus consists of a heat exchanger with an integrated rotor. The walls of the apparatus have an internal cooling cylindrical surface. On the external frame, a thermoelectric battery is installed, which is made in the form of cold and hot junctions. The side with cold junctions is built on the outer surface of the frame, at an external part of the frame that has flat faces at the location of battery installation. The hot junction side is thermodynamically connected to the heat exchanger integrated into the flow circuit.

The apparatus can be optionally equipped with an additional heat exchanger, installed in the external air flow, which can create a closed heat carrier circuit with the battery's heat exchanger using different exchangers.

### BRIEF DESCRIPTION OF THE DRAWINGS

This method is to be performed on the apparatus as shown in drawings provided below:
Figure 1 is a cross-sectional view of a heat exchanger with a thermoelectric battery installed.
Figure 2 shows a hydraulic circuit with apparatus operation during the summer season.
Figure 3 shows a hydraulic circuit with apparatus operation during the off-season and winter time.

### DETAILED DESCRIPTION OF AN EMBODIMENT OF THE INVENTION

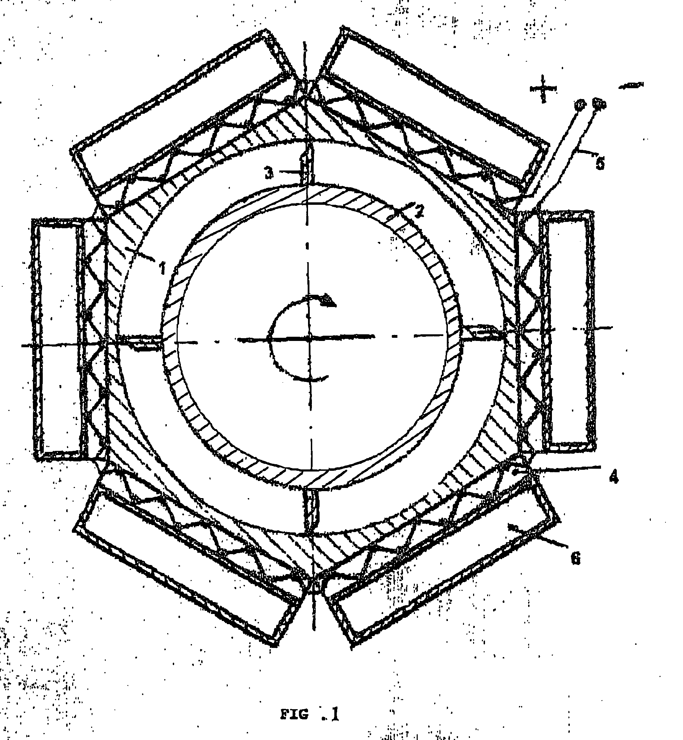

Referring to Fig. 1, the apparatus consists of a heat exchanger, of which frame 1 has an internal cylindrical surface. External surface of frame 1 has flat faces. Rotary shaft 2 is provided with scrapers 3 and is integrated into frame 1. The apparatus is also equipped with a thermoelectric battery 4 powered by a DC network 5. Cold junctions of the battery 4 are situated in the external surface of frame 1, whereas hot junctions of the battery are associated with heat exchanger 6.

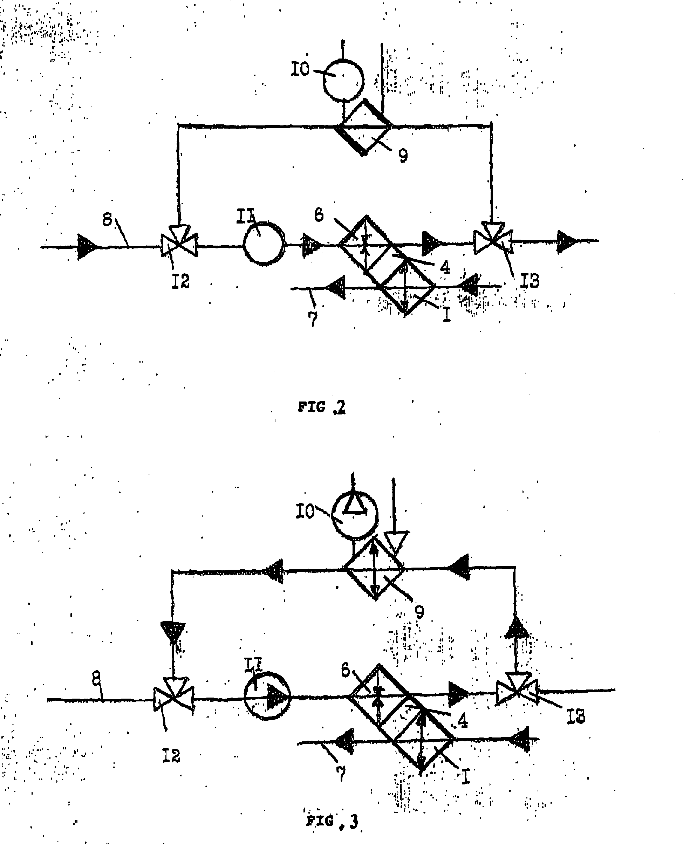

Referring to Figs. 2-3, frame 1 can be integrated into a flow circuit 7 for a margarine mixture, whereas heat exchanger 6 can be built into water line 8.

During winter season, an additional heat exchanger 9, built into the external air flow and equipped with a fan 10 should create, in combination with heat exchanger 6, a closed heat carrier circuit, including for instance, pump 11 and tri-chord faucets 12 and 13.

By supplying power from DC network 5 and cooling the operating regime of the apparatus during the summer season, the cold junctions of the thermoelectric battery 4 are located on the external surface of the frame 1 and the mixture inside is being cooled. Heat taken from this mixture and input by battery 4, heat power is absorbed by water from water line 8 (fig. 2) through hot junctions and heat exchanger 6.

Should the water temperature in the water line be lower than the ambient temperature, during, fore example, the off-season or winter time, heat exchanger 6, tri-chord faucets 12 and 13, heat exchanger 9 and pump 11 would create a closed circuit (Fig. 3). Heat taken from the emulsion in frame 1 by battery 4 is transported outside through heat exchanger 9 by means of fan 10.

During apparatus operation, its reliability, environmental safety due to exclusion of a liquid coolant and a compressor from the cooling process, as well as lower power consumption, are ensured.

### METHOD OF PERFORMANCE

The method of foodstuff emulsion treatment is described below.

### Example 1

Margarine emulsion is pumped into frame 1 of the heat exchanger (length 1.13 m, internal cylindrical wall radius 0.0508 m) equipped with a rotor 2 (radius 0.0405 m) for heat treatment during margarine production, where this emulsion is being cooled.

The number of series frames is 3.

The internal walls of the frame constitute a cooling surface. The temperature of the inner walls is held constant within the limit of minus 10 °C ± 2 °C. Inside of the frame there is a shaft, rotating at a speed of 750-1440 rpm, on the surface of which, numerous tip-up scrapers are attached. Margarine emulsion enters the apparatus from the homogenizer pressurized at 2.5-3 Mn/m² and at a temperature of 34-36°C. Under the influence of the rotor, emulsion is advanced at speed of 3.45-6.89 m/sec. Emulsion should move at such a speed in order to ensure regular cooling of the whole mass during its advancement.

From an outer current source, heat power of 5.0 Wt/cm² enters the thermoelectric battery due to the temperature of the inner surface of the cylinder being held constant. Cooling of the margarine emulsion takes place along the full length of the heat exchanger, and then the margarine emulsion leaves the apparatus having been cooled to a temperature of 14°C.

Cold consumption for 1 MT margarine production amounts to 138 MJ (33'000 kCal). Production output is 2,500 kg/h.

### INDUSTRIAL APPLICABILITY

The disclosed speed of shaft rotation, velocity and flow direction of the product, and the pressure under which margarine emulsion is pumped into the apparatus, ensure more frequent contact of the product particles with the cooling wall, and thus regular formation of numerous crystallization points and small crystals. This invention ensures lower power consumption for each foodstuff piece.

Practical application of this invention allows decreasing power consumption up to 47.7% compared to previously known methods.

**Table 1 contains data on power savings depending on the shaft speed of rotation and foodstuff product handling inside of the apparatus.**

| Speed of rotation, rpm | Product flow handling speed, m/sec | Product consumption supplied to heat treatment, G kg/sec | Power savings, % |
|---|---|---|---|
| 720 | 3.45 | 0.879 | 35.8 |
| 960 | 4.60 | 0.919 | 45.0 |
| 1200 | 5.75 | 1.073 | 50.1 |
| 1440 | 6.89 | 1.140 | 50.7 |
| 500 | 2.41 | 0.733 | 0 |

## Claims

1. A method of treating a margarine emulsion during manufacture including the steps of:
pumping pressurized emulsion into a heat exchanger, the walls of which have an internal cylindrical cooling surface, and
continuous mechanical treatment and advancement of the emulsion to cool the emulsion by a rotor while maintaining a constant temperature of the internal cooling surface using a thermoelectric battery with cold junctions in contact with an external surface of the heat exchanger; **characterized in that** the speed of emulsion advancement is held within a range of 3.45-6.89 m/sec at a rotor speed of 750-1440 rpm.

2. The method of claim 1, wherein the margarine crystallizes as a result of said cooling.

3. The method of any one of claims 1-2, wherein a heat power of 2.5-5.0 Wt/cm² is provided to the thermoelectric battery from an external current source.

## Patentansprüche

1. Ein Verfahren zur Behandlung einer Margarine-Emulsion während der Herstellung, u. a. bestehend aus folgenden Schritten:
Pumpen von Emulsion unter Druck in einen Wärmetauscher, dessen Wände eine innere zylindrische Kühlfläche besitzen; und
kontinuierliche mechanische Behandlung und Weiterbeförderung der Emulsion zur Kühlung der Emulsion mittels eines Rotors bei gleichzeitiger Aufrechterhaltung einer konstanten Temperatur der inneren Kühlfläche mittels einer Thermobatterie mit Kaltlötstellen in Kontakt mit einer Außenfläche des Wärmetauschers; **dadurch gekennzeichnet, dass** die Geschwindigkeit der Emulsionsweiterbeförderung in einem Bereich von 3,45 - 6,89 m/s bei einer Rotordrehzahl von 750 - 1440 U/min gehalten wird.

2. Das Verfahren nach Anspruch 1, wobei sich die Margarine aufgrund der Kühlung kristallisiert.

3. Das Verfahren nach irgendeinem der Ansprüche 1-2, wobei die Thermobatterie von einer externen Stromquelle mit einer Wärmeleistung von 2,5-5,0 W/Cm² versorgt wird.

## Revendications

1. Une méthode de traitement d'une émulsion de margarine durant la fabrication incluant les étapes suivantes :
le pompage d'une émulsion pressurisée dans un échangeur de chaleur dont les parois comportent une surface de refroidissement cylindrique interne, et
le traitement mécanique et l'avancement continus de l'émulsion afin de refroidir l'émulsion par un rotor tout en maintenant la surface de refroidissement interne à une température constante au moyen d'une pile thermoélectrique dont les jonctions froides sont en contact avec une surface externe de l'échangeur de chaleur ; **caractérisé par le fait que** la vitesse d'avancement de l'émulsion est maintenue entre 3,45 et 6,89 m/sec., tandis que le rotor tourne à une vitesse comprise entre 750 et 1440 tr/min.

2. La méthode de la revendication 1, dans laquelle la margarine cristallise par suite dudit refroidissement.

3. La méthode de l'une quelconque des revendications 1 et 2 dans laquelle une chaleur de 2,5 à 5 Wt/cm² est fournie à la pile thermoélectrique par une source de courant externe.
